(19) **Europäisches Patentamt / European Patent Office / Office européen des brevets**

(11) **EP 2 178 073 A1**

(12) # EUROPEAN PATENT APPLICATION

(43) Date of publication:
**21.04.2010 Bulletin 2010/16**

(51) Int Cl.:
***G09G 3/32*** *(2006.01)*

(21) Application number: **09172520.0**

(22) Date of filing: **08.10.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **17.10.2008 KR 20080101946**

(71) Applicant: **Samsung Mobile Display Co., Ltd.**
**Yongin-City**
**Gyeonggi-do (KR)**

(72) Inventors:
- **Lee, An-Su**
  **Chungcheongnam-do (KR)**
- **Lee, Myung-Ho**
  **Chungcheongnam-do (KR)**
- **Song, June-Young**
  **Chungcheongnam-do (KR)**
- **Lee, Kyoung-Soo**
  **Chungcheongnam-do (KR)**

- **Song, Myoung-Seop**
  **Chungcheongnam-do (KR)**
- **Kim, Yun-Tae**
  **Chungcheongnam-do (KR)**
- **Kim, Jong-Soo**
  **Chungcheongnam-do (KR)**
- **Ahn, Jung-Keun**
  **Chungcheongnam-do (KR)**
- **Kim, Min-Cheol**
  **Chungcheongnam-do (KR)**
- **Cho, Sang-Kyun**
  **Chungcheongnam-do (KR)**
- **Shin, Hye-Jin**
  **Chungcheongnam-do (KR)**
- **Kim, Hun-Tae**
  **Chungcheongnam-do (KR)**

(74) Representative: **Neigenfink, Jan Cornelius**
**Gulde, Hengelhaupt,**
**Ziebig & Schneider**
**Wallstraße 58/59**
**10179 Berlin (DE)**

(54) **Organic light emitting display**

(57) An organic light emitting display includes a display unit including a plurality of pixels coupled to scan lines and data lines, a data driver for applying data signals to the data lines, a black data inserting unit between the display unit and the data driver for applying black data to the display unit, the black data being applied between periods in which the data signals are applied, and a timing controller for controlling the data driver and the black data inserting unit.

FIG. 1

EP 2 178 073 A1

**Description**

**BACKGROUND OF THE INVENTION**

**1. Field of the Invention**

The present invention relates to an organic light emitting display.

**2. Description of the Related Art**

Various flat panel displays (FPDs), capable of reduced weight and volume as compared to cathode ray tubes (CRTs), have been developed. FPDs include liquid crystal displays (LCDs), field emission displays (FEDs), plasma display panels (PDPs), and organic light emitting displays, among others.

Among the FPDs, organic light emitting displays display images using organic light emitting diodes (OLEDs) that generate light by recombining electrons and holes. Organic light emitting displays have high response speed and are driven with low power consumption.

A moving picture response time (MPRT) is an index that evaluates the picture quality of an FPD such as an organic light emitting display.

The MPRT measures the movement of moving pictures displayed on the screen of the FPD in real time and captures still images from the moving images by utilizing a charge coupled device (CCD) camera to estimate the degree of definition of the still images. MPRT is suggested as an international standard.

When an MPRT index is low, the degree of definition of an image is low. Therefore, in these instances, the eyes of a user get tired when the user looks at the moving pictures displayed by the FPD.

In particular, in a hold-type FPD, such as an organic light emitting display, a blurring phenomenon in which the screen does not look clear, but instead looks blurry, occurs. This means that a conventional hold-type FPD has a low MPRT index.

**SUMMARY OF THE INVENTION**

Accordingly, the present invention provides an organic light emitting display as set forth in claim 1 in which a black data inserting unit is provided between a data driver and a display unit, such that black data is inserted and provided to the display unit between periods in which data output from the data driver to the display unit is applied, thereby improving the moving picture response time (MPRT) index. Preferred embodiments of the invention are subject of the dependent claims.

**BRIEF DESCRIPTION OF THE DRAWINGS**

The accompanying drawings, together with the specification, illustrate exemplary embodiments of the present invention and, together with the description, serve to explain principles of the present invention.

FIG. 1 is a block diagram schematically illustrating an organic light emitting display according to an embodiment of the present invention;

FIG. 2 is a circuit diagram illustrating a pixel of FIG. 1 according to an embodiment of the present invention;

FIG. 3 is a circuit diagram illustrating the black data inserting unit of FIG. 1 according to a first embodiment of the present invention; and

FIG. 4 is a circuit diagram illustrating the black data inserting unit of FIG. 1 according to a second embodiment of the present invention.

**DETAILED DESCRIPTION OF THE INVENTION**

Hereinafter, certain exemplary embodiments according to the present invention will be described with reference to the accompanying drawings. Here, when a first element is described as being coupled to a second element, the first element may be directly coupled to the second element, or may be indirectly coupled to the second element via one or more additional elements. Further, some of the elements that are not essential to the complete understanding of the invention are omitted for clarity. Also, like reference numerals refer to like elements throughout.

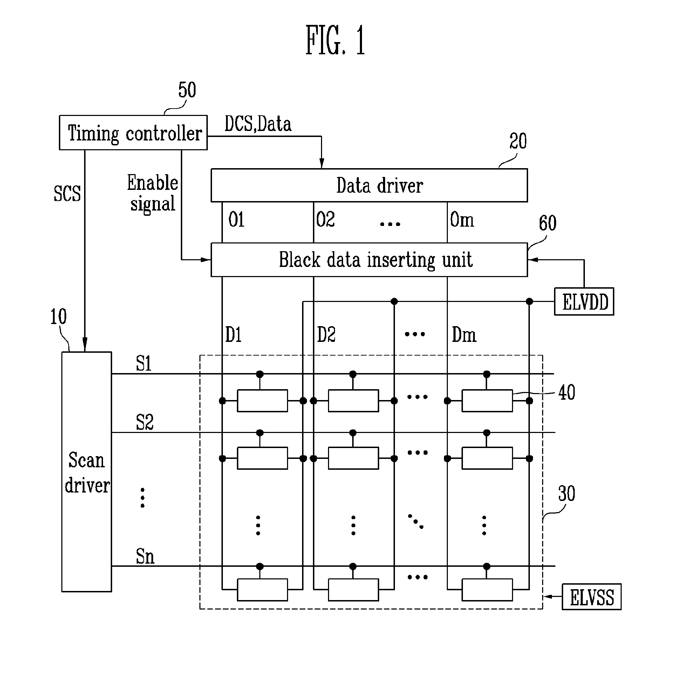

FIG. 1 is a block diagram schematically illustrating an organic light emitting display according to an embodiment of the present invention.

Referring to FIG. 1, the organic light emitting display according to an embodiment of the present invention includes a display unit 30 including a plurality of pixels 40 coupled to scan lines S1 to Sn and data lines D1 to Dm; a scan driver 10 for driving the scan lines S1 to Sn; a data driver 20 for driving the data lines D1 to Dm; a black data inserting unit 60 provided between the display unit 30 and the data driver 20 for providing black data to the display unit 30, the black data being inserted between periods in which data signals output from the data driver 20 are applied to the display unit 30; and a timing controller 50 for controlling the scan driver 10, the data driver 20, and the black data inserting unit 60.

The timing controller 50 generates a data control signal (DCS), a scan control signal (SCS), and an enable signal for controlling the operation of the data inserting unit 60 in response to synchronization signals supplied from the outside.

The data control signal DCS generated by the timing controller 50 is supplied to the data driver 20, the scan control signal SCS is supplied to the scan driver 10, and the enable signal is supplied to the black data inserting unit 60. The timing controller 50 supplies data supplied from the outside to the data driver 20.

The scan driver 10 receives the scan control signal SCS from the timing controller 50. The scan driver 10 generates the scan signals in response to the scan control signals SCS and sequentially supplies the generated scan signals to the scan lines S1 to Sn.

The data driver 20 receives the data control signal DCS from the timing controller 50. The data driver 20 generates the data signals in response to the data control signal DCS and supplies the generated data signals to the data lines D1 to Dm in synchronization with corresponding scan signals. That is, the output channels O1 to Om of the data driver 20 are coupled to corresponding ones of the data lines D1 to Dm.

The display unit 30 receives a first power source ELVDD and a second power source ELVSS from the outside, and supplies them to the pixels 40. The pixels 40 control the current that flows from the first power source ELVDD to the second power source ELVSS through an organic light emitting diode (OLED) in response to the data signals to generate an amount of light corresponding to the data signals. The first power source ELVDD generally has a higher level voltage than the second power source ELVSS.

The organic light emitting display having the above structure is driven in a hold-type method. That is, in a scan period where the scan signals are sequentially supplied to the scan lines S1 to Sn, the data signals are supplied to the pixels 40 that constitute the display unit 30, and in non-scan periods that occupy a majority of one frame period, the data signal supplied to the pixels 40 are maintained so that an image is displayed.

As described above, since the organic light emitting display is driven in the hold-type method, the time frequency characteristic of the light that displays a moving picture deteriorates, such that a space frequency characteristic also deteriorates, thereby causing a blurring phenomenon in a moving picture.

The blurring phenomenon is caused by the integrating effect of an image, which temporarily continues tracing movements in the eyes. Therefore, due to the characteristics of the hold-type method, the organic light emitting display has a drawback in that a viewer may experience blurry images due to non-concurrence between the movement of the eyes and the static image of each frame. That is, the moving picture response time (MPRT) index of the hold-type organic light emitting display is lower than the MPRT index of an impulse type cathode ray tube (CRT).

In order to overcome such drawbacks, a black insertion method has been studied where an entire screen is converted into a black display by displaying images in one frame and then inserting black data before the images of a subsequent frame are displayed.

In the conventional art, in order to generate black data and to provide them to the display unit, a new driving circuit or a new driving method was considered. In such a case, however, circuitry becomes complicated.

Embodiments of the present invention may alleviate such a problem by realizing "black insertion" in a simpler way.

That is, according to embodiments of the present invention, a black data inserting unit 60 is positioned between the display unit 30 and the data driver 20 to provide black data between periods in which data signals output from the data driver 20 to the display unit 30 are applied. Therefore, the black data may be inserted without manipulating the data signals output from the data driver 20 to provide the black data to the display unit 30.

The black data inserting unit 60 includes switches (not shown) coupled to the output channels O1 to Om of the data driver 20. The operations of the switches are controlled by the enable signal provided by the timing controller 50. When the operations are performed, the first power source ELVDD provided to the input terminals of the switches is transmitted to the data lines D1 to Dm of the display unit 30 through the output channels O1 to Om.

The output channels O1 to Om of the data driver 20 correspond to the data lines D1 to Dm arranged in the display unit 30.

At this time, as described above, the first power source ELVDD is the external power source applied to the pixels 40 provided in the display unit 30. According to an embodiment of the present invention, the first power source ELVDD operates as the black data inserted between the data signals in order to improve the picture quality of the organic light emitting display, as well as the power source of the pixels 40.

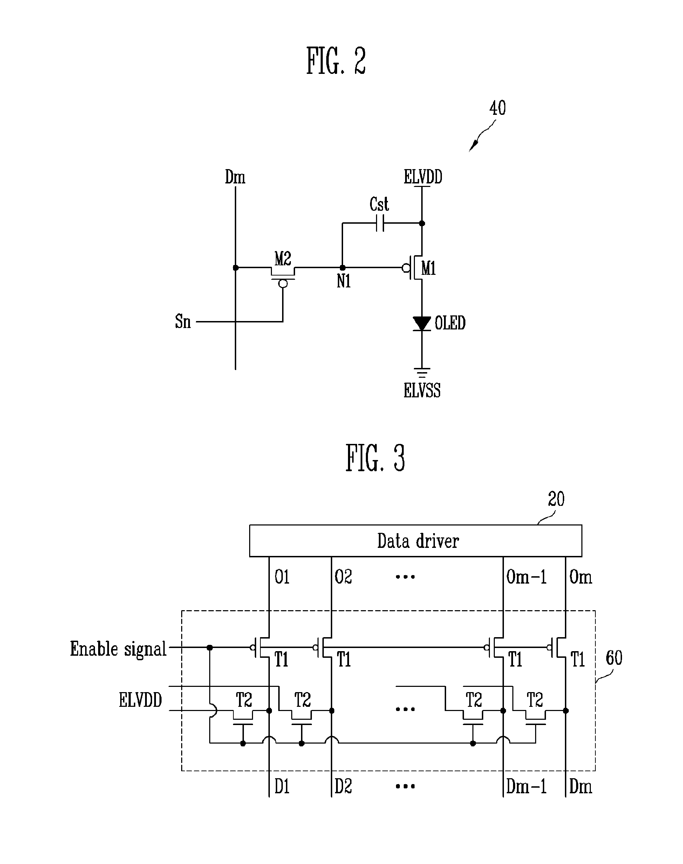

FIG. 2 is a circuit diagram illustrating a pixel of FIG. 1 according to an embodiment of the present invention.

The pixel of FIG. 2 is only an illustrative embodiment and pixels included in the organic light emitting display according to embodiments of the present invention are not limited to the pixel of FIG. 2.

Referring to FIG. 2, the pixel 40 includes a pixel circuit and an organic light emitting diode (OLED). The pixel circuit includes first and second transistors M1 and M2 and a capacitor Cst.

The first and second transistors M1 and M2 can be NMOS transistors or PMOS transistors. In FIG. 2, for example, the first and second transistors M1 and M2 are PMOS transistors. The PMOS transistors each includes a source electrode, a drain electrode, and a gate electrode. The source electrode and drain electrode are physically the same and can be referred to as first and second electrodes. The capacitor Cst includes a first terminal and a second terminal.

In the first transistor M1, a driving element, a source electrode is coupled to a first power source line for supplying the first power source ELVDD, a drain electrode is coupled to the OLED, and a gate electrode is coupled to a first node N1. Therefore, the first transistor M1 controls current flow from the source electrode to the drain electrode in accordance with to the voltage of the first node N1.

In addition, in the second transistor M2, a switching element, a source electrode is coupled to the data line Dm, a drain electrode is coupled to the first node N1, and a gate electrode is coupled to the scan line Sn. In the second transistor M2, the data signal that flows through the data line Dm is selectively transmitted to the first node N1 in accordance with the scan signal transmitted through the scan line Sn.

In the capacitor Cst, a first terminal is coupled to the first power source line for supplying the first power source ELVDD, and a second terminal is coupled to the first node N1 to maintain a voltage between the gate electrode and source electrode of the first transistor M1 for a period of time (e.g., a predetermined period of time), as the organic light emitting display operates using the hold-type method.

The voltage between the gate electrode and source electrode of the first transistor M1 stored in the capacitor Cst corresponds to EQUATION 1.

## Equation 1

$$V_{gs} = ELVDD - V_{data}$$

Here, $V_{gs}$ represents the voltage between the gate electrode and source electrode of the first transistor M1, ELVDD represents the voltage of the first power source line, and $V_{data}$ represents the voltage of the data signal.

The current $I_{OLED}$ that flows through the OLED corresponds to EQUATION 2.

## Equation 2

$$I_{OLED} = \frac{\beta}{2} \left( V_{gs} - V_{th} \right)^2 = \frac{\beta}{2} \left( ELVDD - V_{data} - V_{th} \right)^2$$

Here, $V_{gs}$ represents the voltage between the gate electrode and source electrode of the first transistor M1, ELVDD represents the voltage of the first power source line, $V_{data}$ represents the voltage of the data signal, and $V_{th}$ represents the threshold voltage of a first transistor M1.

Therefore, in each of the pixels 40, current corresponding to a voltage difference between the data signal applied through the data line and the first power source ELVDD is applied to the OLED, which emits light with brightness corresponding to the current, thereby displaying an image.

Therefore, when the first power source ELVDD instead of the data signal is applied to the data line, the value of $V_{gs}$ becomes 0, causing the pixels to display black.

That is, according to an embodiment of the present invention, while an image is displayed by utilizing the data signal applied by the data driver 20, black data, that is, the first power source ELVDD is applied to the data lines D1 to Dm by the black data inserting unit 60 to display black between periods in which the data signals are applied. Therefore, the problem discussed above caused by driving the organic light emitting display in the hold-type method may be alleviated.

The time at which black data is applied can be, for example, between the point in time at which the data signals of one frame are applied and the point in time at which the data signals of the next frame are applied. However, the embodiment of the present invention is not limited thereto.

FIG. 3 is a circuit diagram illustrating the black data inserting unit of FIG. 1 according to a first embodiment of the present invention.

Referring to FIG. 3, the black data inserting unit 60 according to the first embodiment of the present invention is coupled between the output channels O1 to Om of the data driver 20 and the data lines D1 to Dm corresponding to the output channels O1 to Om. The black data inserting unit 60 includes first transistors T1 to which the enable signals provided from the timing controller (50 of FIG. 1) are applied to the gate electrodes, and second transistors T2 that are coupled between the first power source ELVDD and the data lines D1 to Dm, to which the enable signals provided from the timing controller 50 are also applied to the gate electrodes.

In addition, the first transistors T1 and the second transistors T2 are of different types. According to the embodiment of FIG. 3, the first transistors T1 are PMOS transistors and the second transistors T2 are NMOS transistors. However, in an alternate embodiment, the first transistors T1 may be NMOS transistors and the second transistors T2 may be PMOS transistors.

The operation of the black data inserting unit 60 having the above-described structure will be described as follows.

In the embodiment of FIG. 3, the enable signal that enables the black data inserting unit 60 to apply black data is a high level signal that turns on the second transistors T2.

That is, the period in which the black data inserting unit 60 does not apply black data corresponds to the period in which a low level enable signal is applied. During this period, the data driver 20 normally operates to provide the data signals to the pixels (40 of FIG. 1) through the data lines D1 to Dm.

In detail, when the low level enable signal is applied, the first transistors T1 are turned on, such that the output channels O1 to Om of the data driver 20 are coupled to the data lines D1 to Dm through the first transistors T1. Therefore, the data signals output from the data driver 20 are provided to the data lines D1 to Dm to be applied to the pixels 40.

On the other hand, when a high level enable signal is applied, the first transistors T1 are turned off, such that the output channels O1 to Om of the data driver 20 are not coupled to the data lines D1 to Dm. The data lines D1 to Dm are instead coupled to the first power source line to which the first power source ELVDD is applied since the second transistors T2 are turned on.

Therefore, in the period where the high level enable signal is applied, the data signals provided from the data driver 20 are not transmitted to the pixels 40, but instead, the first power source ELVDD is transmitted to the pixels 40.

In this case, as described above, the value of $V_{gs}$ of the driving transistor M1 provided in each of the pixels 40 becomes 0, such that the pixels 40 display black.

With the above-described structure, while a predetermined image is displayed by utilizing the data signals applied by the data driver 20, the black data, that is, the first power source ELVDD, is applied to the data lines D1 to Dm by the black data inserting unit 60 to display black between the periods in which the data signals are applied. Therefore, the problem caused by driving the organic light emitting display in the hold-type method may be overcome by adding a simple circuit.

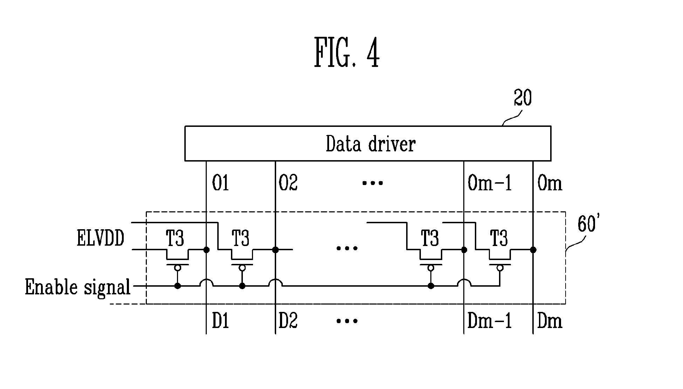

FIG. 4 is a circuit diagram illustrating the black data inserting unit of FIG. 1 according to a second embodiment of the present invention.

Referring to FIG. 4, in a black data inserting unit 60' according to the second embodiment of the present invention, the output channels O1 to Om of the data driver 20 are coupled to corresponding data lines D1 to Dm. The black data inserting unit 60' includes third transistors T3 that are coupled between the first power source ELVDD and the data lines D1 to Dm, where the enable signals provided from the timing controller 50 are applied to gate electrodes.

According to an embodiment of the present invention, the third transistors T3 are PMOS transistors. However, in alternative embodiments, the third transistors T3 may be NMOS transistors.

The operation of the black data inserting unit 60' having the above structure will be described as follows.

In the embodiment of FIG. 4, the enable signal that enables the black data inserting unit 60' to apply black data is a low level signal that turns on the third transistors T3.

That is, the period where the black data inserting unit 60' does not apply black data corresponds to the period in which a high level enable signal is applied. In this case, the third transistor T3 is turned off. Therefore, the data driver 20 operates normally to provide the data signals to the pixels 40 through the data lines D1 to Dm.

On the other hand, when the low level enable signal is applied, the third transistors T3 are turned on, such that the first power source ELVDD is coupled to the data lines D1 to Dm.

Therefore, in the period where the low level enable signal is applied, the data signals provided from the data driver 20 are not transmitted to the pixels 40, but instead, the first power source ELVDD is transmitted to the pixels.

This is because the magnitude of the first power source is larger than or equal to the magnitude of the data signals provided from the data driver 20. Therefore, when the enable signal is at the low level, regardless of the data signals provided from the data driver 20, the first power source ELVDD is transmitted to the pixels through the data lines D1 to Dm.

In this case, as described above, the value of $V_{gs}$ of the driving transistor M1 provided in each of the pixels 40 becomes 0, such that the pixels display black. As described above in FIG. 3, the black data, that is, the first power source ELVDD, is applied to the data lines D1 to Dm by the black data inserting unit 60' to display black between the periods in which the data signals are applied. Therefore, the problem caused by driving the organic light emitting display in the hold-type method may be overcome by adding a simple circuit.

**Claims**

1.  An organic light emitting display, comprising:

    a display unit comprising a plurality of scan lines, a plurality of data lines, and a plurality of pixels arranged at crossing regions of the scan lines and the data lines, each pixel being coupled to a corresponding one of the scan lines and the data lines;
    a scan driver adapted to apply scan signal to the scan lines; and
    a data driver adapted to apply data signals to the data lines during frame periods,
    **characterised by** a black data inserting unit connected between the display unit and the data driver and adapted to apply black data to the display unit; and
    a timing controller adapted to control the data driver and the black data inserting unit to apply the black data between the frame periods.

2.  The organic light emitting display as claimed in claim 1, wherein the black data inserting unit comprises a plurality of switches, each switch having an output terminal coupled to a corresponding one of the data lines.

3.  The organic light emitting display as claimed in claim 2,
    wherein each of the plurality of switches comprises an input terminal connected to a power source and a control electrode and wherein the timing controller is adapted to supply an enable signal to the control electrodes of the plurality of switches.

4.  The organic light emitting display as claimed in one of the preceding claims, wherein the black data inserting unit comprises:

    first transistors coupled between the data driver and corresponding ones of the data lines and having control electrodes coupled to the timing controller; and
    second transistors coupled between a power source and corresponding ones of the data lines and having control electrodes coupled to the timing controller.

5.  The organic light emitting display as claimed in claim 4, wherein the first transistors and the second transistors are different conductivity types of transistors.

6.  The organic light emitting display as claimed in claim 5, wherein the first transistors are PMOS transistors and the second transistors are NMOS transistors or wherein the first transistors are NMOS transistors and the second transistors are PMOS transistors.

7.  The organic light emitting display as claimed in one of the claims 2 or 3, wherein the switches are PMOS transistors.

8.  The organic light emitting display as claimed in claim 7, wherein the data lines are directly coupled to corresponding output channels of the data driver.

9.  The organic light emitting display as claimed in one of the preceding claims, wherein a voltage of the power source is set to a voltage corresponding to black data.

10. The organic light emitting display as claimed in claim 9, wherein the data driver is adapted to provide the data signals such that a voltage of the data signals is less than or equal to the voltage from the power source.

# FIG. 1

# FIG. 2

# FIG. 3

# FIG. 4

Europäisches
Patentamt

European
Patent Office

Office européen
des brevets

**EUROPEAN SEARCH REPORT**

Application Number

EP 09 17 2520

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/296672 A1 (KIM O HYUN [KR] ET AL) 27 December 2007 (2007-12-27) <br> * paragraph [0018] * <br> * paragraph [0100] - paragraph [0105] * <br> * paragraph [0092] - paragraph [0095] * <br> * figures 20-22 * <br> ----- | 1-10 | INV. <br> G09G3/32 |
| X | US 2003/197663 A1 (LEE HAN SANG [KR] ET AL) 23 October 2003 (2003-10-23) <br> * paragraph [0092] - paragraph [0098] * <br> * paragraph [0054] * <br> * figures 5,16,17 * <br> ----- | 1-10 | |
| A | US 2006/103606 A1 (AHN SEONG J [KR] ET AL) 18 May 2006 (2006-05-18) <br> * the whole document * <br> ----- | 1-10 | |
| | | | TECHNICAL FIELDS SEARCHED (IPC) <br><br> G09G |

The present search report has been drawn up for all claims

| Place of search | Date of completion of the search | Examiner |
|---|---|---|
| The Hague | 9 December 2009 | Fanning, Neil |

EPO FORM 1503 03.82 (P04C01)

## ANNEX TO THE EUROPEAN SEARCH REPORT
## ON EUROPEAN PATENT APPLICATION NO.

EP 09 17 2520

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2009

| Patent document cited in search report | | Publication date | Patent family member(s) | | Publication date |
|---|---|---|---|---|---|
| US 2007296672 | A1 | 27-12-2007 | CN<br>CN<br>JP<br>KR | 101093639 A<br>101546520 A<br>2008003542 A<br>20070121466 A | 26-12-2007<br>30-09-2009<br>10-01-2008<br>27-12-2007 |
| US 2003197663 | A1 | 23-10-2003 | CN | 1430092 A | 16-07-2003 |
| US 2006103606 | A1 | 18-05-2006 | CN<br>JP<br>KR | 1773592 A<br>2006139270 A<br>20060045279 A | 17-05-2006<br>01-06-2006<br>17-05-2006 |

EPO FORM P0459

For more details about this annex : see Official Journal of the European Patent Office, No. 12/82